Europäisches Patentamt

European Patent Office

Office européen des brevets

(11) Publication number: **0 435 639 A2**

## (12) EUROPEAN PATENT APPLICATION

(21) Application number: **90314202.4**

(51) Int. Cl.5: **H01L 21/203**

(22) Date of filing: **21.12.90**

(30) Priority: **28.12.89 JP 344471/89**
**28.12.89 JP 344472/89**
**28.12.89 JP 344473/89**

(43) Date of publication of application:
**03.07.91 Bulletin 91/27**

(84) Designated Contracting States:
**DE FR GB**

(71) Applicant: **SHIMADZU CORPORATION**
**1 Kuwabara-cho Nishinokyo Nakakyo-ku**
**Kyoto 615(JP)**

(72) Inventor: **Kobayashi,Yutaka**
**18 Shunei-cho Saiin**
**Ukyo-ku Kyoto 615(JP)**
Inventor: **Shinohara, Makoto**
**12-4 Chajiri-cho Arashiyama**
**Nishikyo-ku Kyoto 616(JP)**
Inventor: **Ogawa, Kiyoshi**
**27 Shimogamo Hagigakakiuchi-cho**
**Sakyo-ky Kyoto 606(JP)**
Inventor: **Ohtani, Fumihiko Melody Heim**
**Nagaokakyo 106 3-11-11 Kaiden**
**Nagaokakyo-shi Kyoto 617(JP)**
Inventor: **Kishihara, Hiyoyuki**
**18 Shunei-cho Saiin Ukyo-ku**
**Kyoto 615(JP)**

(74) Representative: **Smith, Philip Antony et al**
**REDDIE & GROSE 16 Theobalds Road**
**London WC1X 8PL(GB)**

(54) **Method of thin film formation.**

(57) A method of forming a thim film of a compound substance on a substrate comprises a process of cleaning the substrate by bombarding the same with a high energy molecular or cluster beam consisting of one of the chemical elements constituting the above compond substance whose thin film is to be formed. Another method is of forming a dislocation-free thin film on a compound substance by depositing, prior to forming an aiming film, a buffer layer on a substrate, the buffer layer being formed by alternately applying to the substrate a high-energy and a low-energy molecular beams each of which consists of each of the chemical elements constituting the above compond substance.

EP 0 435 639 A2

## METHOD OF THIN FILM FORMATION

Background of the Invention

The present invention relates to a method of forming a thin film on a substrate, and more particularly to a method of forming a compound semiconductor film such as a gallium arsenide film on a substrate of a simple-substance semiconductor such as silicon.

Application of III-V compound semiconductors such as GaAs is prevailing in the field of quantum electronics and high-speed electronic devices. Such compound semiconductors are mostly used in the form of a thin film formed on a simple-substance semiconductor substrate (such as a silicon substrate) or on a similar compound semiconductor substrate by means of the MBE (Molecular Beam Epitaxy) method, MOCVD (Metal-Organic Chemical Vapor Deposition) method or the like. However, there are many problems left unsolved in forming a compond semiconductor film. Under the circumstances it is urgently expected to establish the technology of forming a defect-free stable GaAs film on a silicon substrate, because the GaAs film formation on a silicon substrate makes it possible to combine a GaAs device with a conventional semiconductor device which is in most cases formed on a silicon substrate.

One of the previously mentioned problems left unsolved lies in the coventional method of finally cleaning a substrate. The substrate, which is now supposed to be of silicon, has conventionally been heated up, in a vacuum chamber, to a temperature of 850 °c to 1000 °C to remove a thin oxide layer formed on the surface. The thus heat-treated silicon substrate has its surface reconstructed to have a so-called 2 x 1 or 2 x 2 structure. Such surface structures, which are evidence that the substrate has its surface made free from the oxide layer, can be confirmed by observing a RHEED (Reflection High Energy Electron Diffraction) pattern on the surface. If such surface structures are formed, the RHEED pattern shows additionl streaks each of which appears in each of the spaces having remained between adjacent bulk streaks. Although the cleaning of the substrate is achieved and confirmed in the manners mentioned above, the heat treatment at a very high temperature of or near 1000 °C occasionally causes the substrate to be warped or strained resulting in a quality deterioration of the substrate.

Another major problem to be solved relates to the method of forming a film of a compound substance such as GaAs on a substrate of a simple-substance such as silicon. Since the substance of a film to be formed and that of a substrate are different from each other, so that it is often difficult to form a satisfactory film. For instance, if a GaAs film is formed directly on a silicon substrate particularly by means of epitaxy, the film formed is often accompanied by lattice defects such as dislocations, owing to the difference in lattice constants and thermal expansion coefficients between the film and the substrate. Conventionally, it has been tried to suppress the development of such dislocations, for example, by preforming a buffer layer between the GaAs film and the silicon substrate, by repeating in-situ annealing operations during the process of forming the GaAs film or by combininig these two methods. The buffer layer, which can be constituted variously, is usually made in the form of a densely Si-doped GaAs layer or of a multilayer consisting of several alternately stacked single layers of InGaAs (or AlGaAs) and GaAs, the multilayer showing a distorted superlattice constitution.

However, such conventional methods of suppressing the development of threading dislocations also have various disadvanges. Theincorporation of repeated annealing operations not only causes the completion of film formation to take a long time, but also is apt to result in impurity diffusion. The employment of the In(or Al)GaAs-GaAs mulilayered buffer not only necessiates an aditional substance In or Al but also makes the film formation apparatus and process very complicated, while the Si-doped buffer has the possibility that the GaAs film formed has its quality deteriorated by possible Si diffusion into the film. Further, some of the conventional methods occasionally fails to suppress the dislocation development in the film formed.

Objects and Summary of the Invention

The present invention aims at resolving the above problems involved in the conventional method of thin film formation, and makes it an object to provide an improved method of forming a thin film of a compound substance such as gallium arsenide on a substrate with the substrate made free from surface oxide layer without being warped or distorted by heat treatment.

Another object of the present invention is to provide an improved method of forming a thin film of a compound substance such as gallium arsenide on a substrate of a different substance such as silicon with dislocation developmentsuppressed.

To achieve the above objects, first, the final cleaning of a substrate on which a film is to be formed is preferably executed by bombarding, to remove a surface oxide layer, the substrate with an ion beam made by ionizing a molecular beam consisting of one kind of the chemical elements constituting the film to be formed. Secondly, if a buffer layer is necessarily incorporated between the film to be formed and the substrate, the buffer layer is prepared in the form of a multilayer made by stacking, alternately at a higher energy and at a lower energy, several single layers of the same substance as that constituting the film to be finally formd.

According to the present invention, the substrate made clean with the surface oxide layer removed is kept free from the deterioration due to warping and strains, because the substrate cleaning is by means of ion-beam bombarding by which the substrate is never heated up to such a high temperature near 1000 $^\circ$C that is attained when cleaned by means of heat treatment. Further, the film finally formed in accordance with the invention has its threading dislocations decreased remarkably, since, within the boundary between the film and the multilayered buffer region, there arise forces to bend dislocations at a right angle.

Brief Description of the Drawings

In the following the present invention is described in further details on reference to the accompanying drawings, in which:

Fig. 1 shows an apparatus for executing a first embodiment of the methods according to the present invention;

Figs. 2(A) and 2(B) schematically illustrate the process of the second embodiment;

Figs. 3(A) and 3(B) show sketched RHEED patterns obtained from substrates used in the seconcd embodiment;

Fig. 4 shows an apparatus for executing a second embodiment of the methods according to the present invention;

Fig. 5(a) to 5(c) schematically illustrate the process of the second embodiment; and

Fig. 6 shows a sketched TEM pattern of a film formed by the second embodiment.

Detailed Description of the Invention

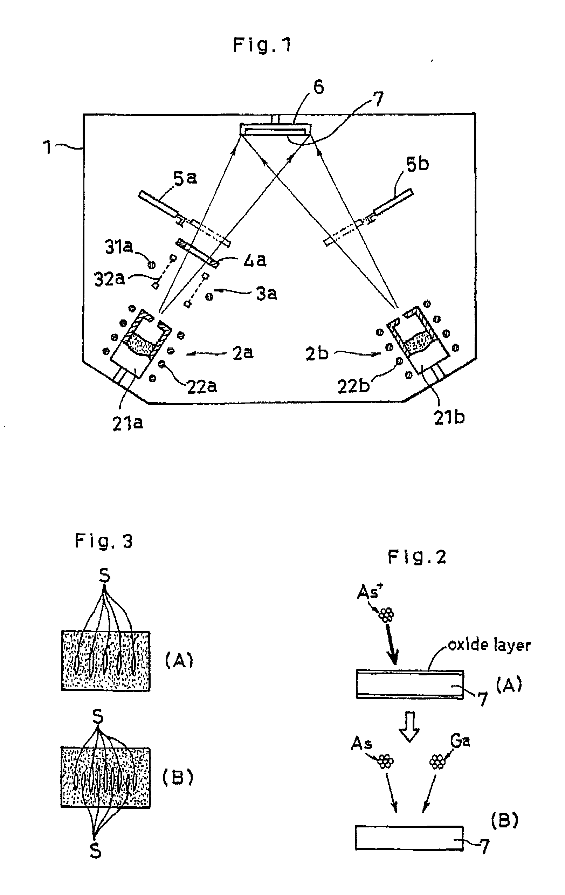

Referring to Fig. 1, which shows an apparatus for forming a GaAs film on a silicon substrate according to a first embodied method of the invention, there are provided in a vacuum chamber 1 a pair of ovens 2a and 2b for respectively generating a As and an Ga molecular beams, an ionizer 3a for ionizing the As molecular beam, an ionized As molecular beam accelerating electrode 4a, externally operable shutters 5a and 5b respectively for the As and the Ga molecular beams, and a substrate holder 6 for holdinga substrate 7 on which a GaAs film is to be formed. The substrate holder 6 is provided with a heater (not-shown) for keeping the substrate 7 at about 600 $^\circ$C which is a temperature suitable for forming a film. The ionizer 3a consists of a heater 31a and a grid electrode 32a, while each of the ovens 2a and 2b consists of a crucible 21a or 21b and a heater 22a or 22b for heating the crucible 21a or 21b to evaporate As or Ga. Further, between the ionized-molecular beam accelerating electrode 4a and the crucible 21a, an acceleration voltage of about 1.3 kV can be supplied from a not-shown DC voltage source.

After the crucibles 21a and 21b are filled with As and Ga, respectively, with a Si substrate 7 mounted on the substrate holder 6, then the vacuum chamber 1 is evacuated. After a sufficient vacuum is formed in the chamber 1, both the ovens 2a and 2b are heated with the shutters 5a and 5b closed.

When both the ovens 2a and 2b begin to evaporate As and Ga, respectively, the ionizer is put into operation with the the electrode 4a voltage-supplied (about 1.3 kV), and then only the shutter 5a is opened. An As molecular beam, in which As molecules (atoms) often constitute clusters, spurts from the oven 2a into the ionizer 3a, where the As molecular beam is ionized by the thermal electrons emitted from the heater 31a and accelerated by the grid electrode 32a. The thus ionized molecular beam is accelerated by the voltage of about 1.3 kV supplied to the electrode 4a, and dashes against the surface of the substrate 7 (Fig. 2(A)). With the substrate 7 thus kept spattered with the thus ionized and accelerated As molecular beam for several minutes, the substrate 7 has its surface etched to a depth of about a few nanometers resulting in the complete removal of a surface oxide layer.

After the above process of cleaning the substrate 7, the ionizer 3a and the electrode 4a are put into non-operation, and at the same time the shutter 5b is opened. Thus, both Ga and As molecular beams are applied to the substrate 7 (Fig. 2(B)) to make them form thereon a GaAs film by means of molecular beam epitaxy (MBE).

The above first embodied method of the invention can be modified, in general, by exchanging the ovens 2a and 2b with each other.

Incidentally, the completeness of substrate cleaning has been confirmed by RHEED patterns taken, as shown in Figs. 3(A) and 3(B), respectively before and after the substrate 7 is spattered with the ionized As molecular beam. The RHEED pattern shown in Fig. 3(A) gives only bulk streaks Sa, while in Fig. 3(B) the bulk streaks Sa are accompanied by additional streaks Sb each of which is located between each pair of bulk streaks Sa. These RHEED patterns show the substrate cleaning complete, as is described in Background of the Invention.

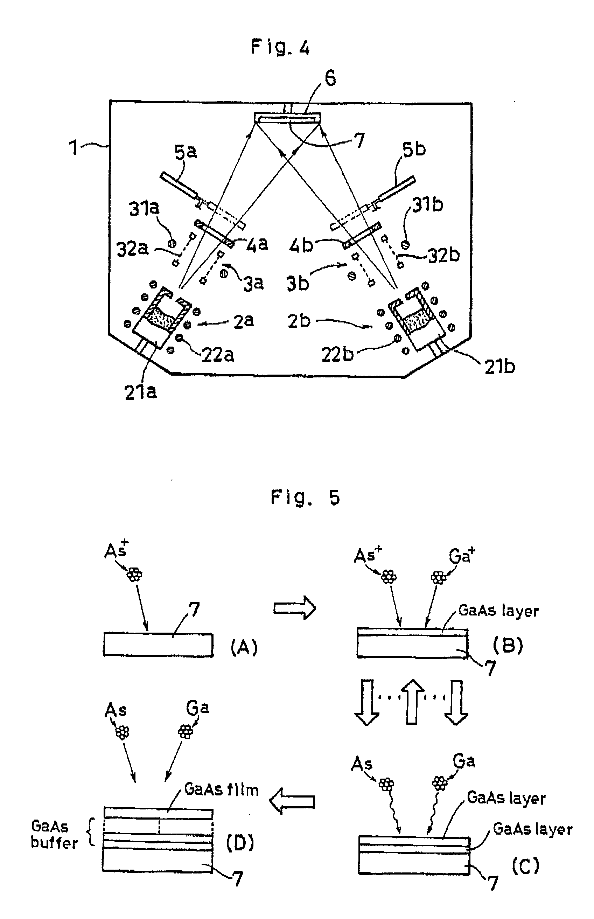

Fig. 4 shows an apparatus for executing a second embodied method of the invention. The apparatus of Fig. 4 is differs from that of Fig. 1 only in that also the Ga evaporating oven 2b is accomanied by a ionizer 3b and an acceleration electrode 4b corresponding to the ionizer 3a and the electrode 4a accompanying the As oven 2a. The ionizer 3a consist of a heater 31b and a grid electrode 32b similarly in the case of the ionizer 3a. Futher, the functions of the ionizer 3b and the electrode 4b are not described particularly, because they are the same as those of the ionizer 3a and the electrode 4a. In the following the second embodied method of the invention is descibed, but such preparation processes as the evacuation of the vacuum chamber 1 have their descriptions omitted.

After the substrate 7 is made clean and free from a surface oxide layer by being spattered (Fig. 5(A)), as in the case of the first embodied method, with an ionized As molecular beam, the substrate 7 is applied with both ionized Ga and As molecular beams with the beams accelerated by a voltage of about 1.3 kV supplied to the electrodes 4a and 4b, until a first GaAs layer of a thickness of about 1.5 $\mu$m is formed directly on the substrate 7 (Fig. 5(B)). After the first GaAs layer is thus formed with ionized and accelerated high-energy molecular beams of Ga and As, the the ionization and acceleration of both the beams are ceased to form on the first GaAs layer a second GaAs layer of a thickness of about 1.5 $\mu$m by applying non-ionized and non-accelerated low-energy molecular beams of Ga and As to the substrate 7 (the 1st GaAs layer, if spoken strictly) (Fig. 5(C)). These processes of forming a multilayered GaAs stratum with high-energy and low-energy molecular beams applied alternately may be repeated if necessary, but the fimal thickness of the buffer preferably remains about 4 $\mu$m.

Then, an aiming GaAs film is finally formed on the buffer stratum by applying thereon non-ionized and non-accelerated molecular beams of Ga and As (Fig, 5(D)).

Although in the multilayered buffer stratum forming process of the above second embodied method the ionized high-energy molecular beams application precedes the non-ionized low-energy molecular beams application, the invention can be executed with the beam application order inverted.

Further, although in the second embodied mehtod the low-energy molecular beams are non-ionized non-accelerated beams, they may be ionized molecular beams accelerated by a voltage of about 0.1 kV.

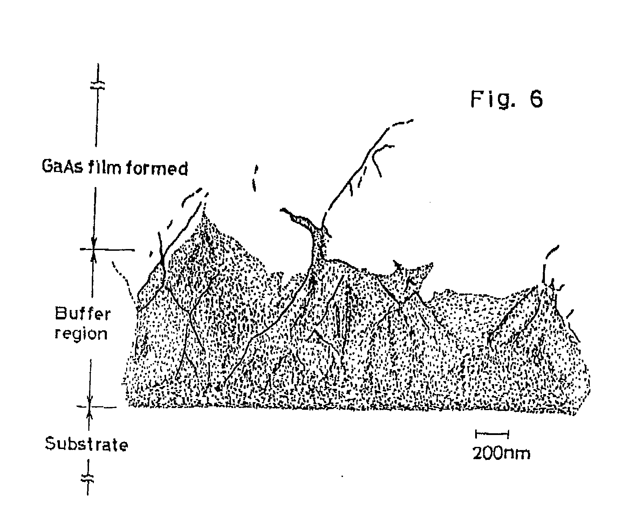

Referring to Fig. 6, which shows a sketched TEM pattern of the GaAs film formed according to the above second embodied method, many dislocations seen in the buffer region are decreased in number remarkably.

Although the invention is described in the above in conjunction with the film formation by means of molecular or cluster beam epitaxy, it is needless to say that the present invention can be applied to other film forming methods such as those using ion beams or ion cluster beams with the apparatus modified purposefully.

## Claims

1. A method of forming a film of a compound substance on a substrate, said method comprising:
   a process of bombarding said substrate with an ionized molecular or ionized cluster beam made up of one kind of the chemical elements constituting said compound substance; and
   a process of evaporating, onto said substrate, molecular or cluster beams each of which consits of each of the chemical elements constituting said compound substance.

2. A method of forming a film of a compound substance on a substrate, said method comprising:
   a first process of applying to said substrate high-energy molecular or cluster beams each of which consists of each of the chemical elements constituting said compound substance; and
   a second process of applying to said substrate low-enrgy molecular or cluster beams each of which consists of each of the chemical elements constituting said compound substance.

3. A method of forming a film of a compound substance on a substrate, said method comprising:
   a first process of applying to said substrate high-energy molecular or cluster beams each of which consists of each of the chemical elements constituting said compound substance;
   a second process of applying to said substrate low-enrgy molecular or cluster beams each of which consists of each of the chemical elements constituting said compound substance; and
   a third process of repeating said second process and said third process.

4. A method as defined in claim 2 or 3, wherein said high-energy molecular or cluster beams are ionized molecular or cluster beams accelerated in an electric field.

5. A method as defined in Claim 2 or 3, wherein said first process precedes said second process.

6. A method as defined in Claim 2 or 3, wherein said second process precedes said first process.

7. A method as defined in Claim 4, wherein said first process precedes said second process.

8. A method as defined in Claim 4, wherein said second process precedes said first process.

9. A method as claimed in claim 1 in which after the bombardment of the surface and before the evaporation process a buffer layer is applied by alternately applying high-energy and low-energy molecular or cluster beams each of which consists of one of the chemical elements constituting the compound substance.

Fig.1

Fig. 3

Fig.2

EP 0 435 639 A2

Fig. 4

Fig. 5

7

Fig. 6

GaAs film formed

Buffer region

Substrate

200nm